# EUROPÄISCHE PATENTANMELDUNG

(11) **EP 2 784 528 A1**
(43) Veröffentlichungstag der Anmeldung: **01.10.2014**
(21) Anmeldenummer: 14157838.5
(22) Anmeldetag: 05.03.2014
(51) Int. Cl.: G01R 31/36, B60L 11/18, H01M 10/48

(54) **Bereitstellen einer Zustandsinformation mindestens einer Batteriezelle mittels eines Zählers**

(30) Priorität: 28.03.2013 DE 102013205549
(71) Anmelder: Siemens Aktiengesellschaft, 80333 München (DE)
(72) Erfinder: Falk, Rainer, 85586 Poing (DE)

(57) **Zusammenfassung**

Dabei wird mindestens ein Zustandswert ermittelt, wobei der mindestens eine Zustandswert aus einer physikalischen Eigenschaft der Batteriezelle und/oder einem physikalischen Vorgang, dem die Batteriezelle vor dem Ermitteln ausgesetzt war, gebildet wird. Es wird ein Zählerwert in Abhängigkeit von dem mindestens einen Zustandswert nach einer vorgebbaren Zuordnungsvorschrift zugeordnet und der Zählerwert in einem Speicher des Zählers hinterlegt, falls der Zählerwert in eine vorgegebene Richtung von einem aktuell in dem Speicher abgelegten Zählerwert abweicht.

## Beschreibung

Die Erfindung betrifft ein Verfahren und eine Vorrichtung zum Bereitstellen einer Zustandsinformation einer Batteriezelle mittels eines Zählers.

Eine Batterie ist eine wesentliche Komponente eines Elektrofahrzeuges. Von der Qualität und der Unversehrtheit einer Fahrzeugbatterie hängt entsprechend der Zeitwert eines Elektrofahrzeuges wesentlich ab. Der Zustand einer Fahrzeugbatterie ist vergleichbar mit der Laufleistung eines über einen Verbrennungsmotor angetriebenen Fahrzeuges. Daher ist der Zustandswert einer Fahrzeugbatterie von ähnlicher Relevanz wie der Wert eines Kilometerzählers.

Es sind Tamperschutzmaßnahmen bekannt zum Schutz von Energieverbrauchseinrichtungen wie beispielsweise Stromzählern oder intelligenten Messgeräten, sogenannten Smartmetern. Dabei wird eine physikalische Manipulation detektiert oder ein digital ermittelter Messwert kryptographisch geschützt bereitgestellt.

Es sind Hodometer bekannt, die gegen Manipulation geschützt sind. Dabei findet eine Ver- und Entschlüsselung eines Kilometerstandes statt.

Es sind aus dem Stand der Technik monotone Zähler bekannt, welche eingeschränkt modifizierbar sind. Dabei ist beispielsweise bei Telefonkarten nur das Hoch- oder nur das Heruntersetzen eines Zählers um einen Wert möglich, wie aus W. Rankl, "Chipkartenanwendungen", Carl Hanser Verlag München Wien, 2006, bekannt.

Es besteht ein Bedarf, eine korrekte und manipulationsgeschützte Information zu einem Degradationszustand einer Fahrzeugbatterie bereitzustellen.

Der vorliegenden Erfindung liegt die Aufgabe zugrunde, eine Zustandsinformation einer Batteriezelle mittels eines manipulationsgeschützten Zählers bereitzustellen.

Diese Aufgabe wird durch ein Verfahren und eine Vorrichtung gemäß den in den unabhängigen Ansprüchen angegebenen Merkmalen gelöst. Vorteilhafte Ausführungsformen und Weiterbildungen sind in den Unteransprüchen angegeben.

Die im Folgenden genannten Vorteile müssen nicht notwendigerweise durch die Gegenstände der unabhängigen Ansprüche erzielt werden. Dabei kann es sich auch um Vorteile handeln, welche lediglich durch einzelne Ausführungsformen oder Weiterbildungen erzielt werden.

Erfindungsgemäß weist ein Verfahren zum Bereitstellen einer Zustandsinformation mindestens einer Batteriezelle mittels eines Zählers folgende Schritte auf:
- Ermitteln mindestens eines Zustandswertes, wobei der mindestens eine Zustandswert in Abhängigkeit von einer physikalischen Eigenschaft der Batteriezelle und/oder einem physikalischen Vorgang, dem die Batteriezelle vor dem Ermitteln ausgesetzt war, gebildet wird;
- Zuordnen eines Zählerwertes in Abhängigkeit von dem mindestens einen Zustandswert nach einer vorgebbaren Zuordnungsvorschrift;
- Hinterlegen des Zählerwertes in einem Speicher des Zählers, falls der Zählerwert in eine vorgegebene Richtung von einem aktuell in dem Speicher abgelegten Zählerwert abweicht;
- Bereitstellen der Zustandsinformation in Abhängigkeit von dem Zählerwert.

Aus dem Stand der Technik ist es bekannt, einen so genannten Gesundheitszustand, auch State of Health oder kurz SOH genannt, einer Batterie zu ermitteln. Dadurch wird ein Degradationsgrad festgelegt, welcher Aussage über die Qualität einer Batterie gibt. Durch das Ermitteln von Parametern einzelner Batteriezellen einer Batterie kann so beispielsweise auf Ersatzzellen der Batterie umgeschaltet werden. Die Berechnungsvorschriften für einen SOH-Wert sind dabei im Stand der Technik unterschiedlich. Es können beispielsweise Gewichtungen zwischen verschiedenen gemessenen Sensordaten vorgenommen werden.

Durch die Kombination eines Zustandswertes einer Batteriezelle mit einem manipulationsgeschützten Zähler wird verhindert, eine unzulässige Verbesserung eines SOH-Wertes einer Batterie vorzutäuschen.

Die Zustandsinformation der mindestens einen Batteriezelle wird in Abhängigkeit von dem Zählerwert bereitgestellt, welcher nur dann aus dem Speicher abgefragt werden kann, wenn er dort erfolgreich hinterlegt wurde. Das Hinterlegen ist allerdings nur dann möglich, wenn der Zählerwert vorgegebene Bedingungen erfüllt. Er muss in eine fest vorgegebene Richtung von einem aktuell in dem Speicher abgelegten Zählerwert abweichen. Er kann also beispielsweise nur inkrementiert oder nur dekrementiert werden.

Der Zählerwert wird in Abhängigkeit von dem mindestens einen Zustandswert zugeordnet. Dies erfolgt nach einer vorgebbaren Zuordnungsvorschrift. Somit arbeitet der Zähler in einer konfigurierbaren Weise. Durch die Zuordnung kann beispielsweise festgelegt werden, wie groß ein Toleranzbereich sein soll, innerhalb dessen das Hinterlegen des Zählerwertes nicht stattfinden soll, weil eine Zählerwertkategorie nicht verlassen wird. Dann wird beispielsweise der Zählerwert nicht erneut abgespeichert oder der aktuell in dem Speicher abgelegte Zählerwert nicht überschrieben. Bei einer Abfrage wird der aktuell in dem Speicher abgelegte Zählerwert herausgegeben. Ferner kann hier eine Feinheit einer Unterteilung in Zustandsklassen festgelegt werden.

Somit wird ein Verfahren bereitgestellt, welches einerseits eine Manipulation einer Zustandsinformation einer Batteriezelle, welche einen besseren als den tatsächlichen SOH-Wert vortäuscht, verhindert. Andererseits bietet das Verfahren genügend Flexibilität, um Messungenauigkeiten, welche beim Ermitteln des Zustandswertes beispielsweise über Sensoren auftreten, abzugrenzen von einer Manipulation.

Gemäß einer Ausführungsform wird der Zählerwert als diskrete Zahl codiert zugeordnet. Liegt der Zählerwert beispielsweise als ganze positive Zahl im Wertebereich von 0 bis 100 vor, so kann auch der Zählerwert nach einer vorgebbaren Zuordnungsvorschrift als ganze positive Zahl codiert werden und insbesondere festgelegt werden, dass jeweils zwei benachbarte Werte des Zustandswertes einem Wert in Form einer ganzen natürlichen Zahl als Zählerwert entsprechen. Dabei kann der Maximalwert des Wertebereiches den vollen, maximalen SOH-Wert codieren. Dies entspricht einem Herunterzählen des Zählers, also einem Verringern des Zählerwertes im Laufe einer Beanspruchung der Batteriezelle, welche mit einer Reduzierung des SOH-Wertes gleichgesetzt wird.

Ebenso ist eine komplementäre Codierung möglich, bei der der Zählerwert 0 den Maximalwert einer Batteriezelle codiert und entsprechend bei einer Reduzierung des SOH-Wertes der Zählerwert hochgezählt wird.

Gemäß einer Ausführungsform wird der Speicher durch Sicherheits-Sicherungen, im Folgenden Security Fuses oder Sicherung genannt, gebildet. Dabei wird beispielsweise zum Durchführen eines Zählerschrittes von einem Ausgangswert auf einen um einen Schritt erniedrigten Wert eine Sicherung durchgebrannt. Dadurch wird beispielsweise ein Kontakt auf einem Schaltkreis unterbrochen, was insbesondere durch Strom, Spannungs- oder Widerstandsmessungen detektiert werden kann. Dieser Schritt kann nicht rückgängig gemacht werden, da die Sicherung zerstört ist und nicht wiederhergestellt werden kann. Dadurch wird ein monotoner Zähler realisiert: Bei Übergeben eines Zählerwertes, für dessen Speicherung eine Anzahl an Sicherungen unversehrt vorhanden sein müsste, die größer ist, als die bestehende Anzahl unversehrter Sicherungen, wird dieser Zählerwert nicht gespeichert. Bei einer Anfrage wird somit dieser Zählerwert nicht ausgegeben und eine Manipulation des Speichers ist erschwert.

Gemäß einer weiteren Ausführungsform wird der Speicher durch einen nicht flüchtigen Speicher mit einer Ansteuerungslogik gebildet.

Beispielsweise wird ein Flash-Speicher oder ein elektrisch löschbarer programmierbarer Nur-Lese-Speicher, im Folgenden mit der englischen Kurzform EEPROM für Electrically Erasable Programmable Read-Only Memory bezeichnet, verwendet, der mittels logischer Schutzmaßnahmen verhindert, dass ein Zählerwert hoch- oder heruntergesetzt wird, indem entsprechend kein Befehl zum Inkrementieren oder Dekrementieren vorgesehen ist.

Gemäß einer weiteren Ausführungsform wird die physikalische Eigenschaft aus einer Kombination aus physikalischen Werten gebildet und die physikalischen Werte sind insbesondere ein Widerstandswert, ein Kapazitätswert, ein Spannungswert oder ein Selbstentladungswert. So können Daten über die Batteriezelle, die beispielsweise in einem Elektrofahrzeug verbaut ist, erfasst werden.

In Abhängigkeit von der Qualität der Batteriezelle, insbesondere der Qualität der Batteriezelle zum Zeitpunkt des Einbaus in das Elektrofahrzeug, variieren diese physikalischen Werte. In Abhängigkeit von dem Hersteller der Batterie können hier Abweichungen auftreten. Auch eine Alterung der Batteriezelle, unabhängig von der Benutzung während der Lebensdauer, wird hier erfasst.

Gemäß einer weiteren Ausführungsform wird der physikalische Vorgang aus einem oder mehr Schritten gebildet und für jeden Schritt ein Parameter ermittelt, insbesondere eine Anzahl von Lade- und/oder Entladevorgängen, eine Anzahl von TiefEntladevorgängen, eine Umgebungstemperatur oder eine Erschütterung.

So können auch Umstände erfasst werden, unter welchen die Batteriezelle verwendet wurde. Beispielsweise wird so erfasst, wenn eine Batterie in einem Unfallwagen verbaut war. Auch aufgetretene Tief-Entladevorgänge werden bemerkt, welche für die Lebensdauer der Batteriezelle nachteilig sind, andererseits aber über das reine Erfassen von Entladevorgängen unabhängig von der Tiefe der Entladung nicht erkennbar sind.

Gemäß einer Weiterbildung wird mindestens ein zweiter Zustandswert einer zweiten Batteriezelle ermittelt und einem gemeinsamen Zustandswert, der aus dem Zustandswert und dem zweiten Zustandswert zusammengesetzt wird, der Zählerwert zugeordnet.

So werden auf vorteilhafte Weise mehrere Batteriezellen einer Batterie durch den Manipulationsschutz überwacht.

Gemäß einer weiteren Weiterbildung wird die Zustandsinformation durch eine kryptographische Prüfsumme geschützt bereitgestellt.

Dazu wird bei einer Abfrage des Zählers beispielsweise ein aktueller Inhalt des Zählers über ein Kommunikations- oder Diagnoseschnittstelle bereitgestellt. Der Inhalt wird dann beispielsweise über eine digitale Signatur, wie insbesondere ein RSA-Verfahren, DSA-Verfahren (Kurzform für Digital Signatur Algorithmus-Verfahren) oder ECC-DSA-Verfahren (ECC kurz für Elliptic Curve Cryptography oder Elliptische-Kurven-Kryptographie) geschützt. Außerdem ist die Verwendung von Nachrichten-Authentifikations-Codes, sogenannten Message-Authentication-Codes oder kurz MAC, insbesondere HMAC-SHA1 (Kurzform für Hash-basierter MAC und sicherer Hash-Algorithmus) oder AES-CBCMAC (kurz für Cipher Block Chaining Message Authentication Code oder Blockverschlüsselungs-MAC), vorteilhaft.

Gemäß einer Weiterbildung umfasst die Zustandsinformation ferner eine Identifizierungsinformation der mindestens einen Batteriezelle.

Dadurch wird der Schutz gegenüber einer Manipulation weiter erhöht. Insbesondere kann so erkannt werden, ob zum Zeitpunkt einer Zählerabfrage die Batteriezelle vorschriftsgemäß verbaut ist.

Gemäß einer Weiterbildung umfasst die Zustandsinformation ferner Informationen über registrierte Umgebungsdaten der mindestens einen Batteriezelle.

So können beispielsweise Informationen über einen Hersteller oder ein Einbaudatum der Batterie abgefragt werden, so dass eine Manipulation an einer Fahrzeugbatterie beispielsweise eines Elektrofahrzeuges, erschwert wird.

Die Erfindung umfasst ferner eine Vorrichtung zum Bereitstellen einer Zustandsinformation in mindestens einer Batteriezelle, umfassend:
- eine Sensoreinheit zum Ermitteln mindestens eines Zustandswertes aus einer physikalischen Eigenschaft der Batteriezelle und/oder einem physikalischen Vorgang, dem die Batteriezelle vor dem Ermitteln ausgesetzt war;
- eine Analyseeinheit zum Zuordnen eines Zählerwertes in Abhängigkeit von dem mindestens einen Zustandswert nach einer vorgebbaren Zuordnungsvorschrift;
- einen Zähler und einen Speicher des Zählers zum Hinterlegen des Zählerwertes, falls der Zählerwert in eine vorgegebene Richtung von einem aktuell in dem Speicher abgelegten Zählerwert abweicht;
- eine Kommunikationsschnittstelle zum Bereitstellen der Zustandsinformation in Abhängigkeit von dem Zählerwert.

Gemäß einer Ausführungsform umfasst die Vorrichtung ferner eine weitere Einheit zur Verwendung nach einem der Verfahrensschritte gemäß der oben genannten Ausführungsformen oder Weiterbildungen.

Die Erfindung wird nachfolgend mit Ausführungsbeispielen anhand der Figuren näher erläutert. Es zeigen:
- Figur 1: einen schematischen Ablauf des Verfahrens gemäß einem ersten Ausführungsbeispiel der Erfindung;
- Figur 2: eine schematische Darstellung der Vorrichtung gemäß einem zweiten Ausführungsbeispiel der Erfindung.

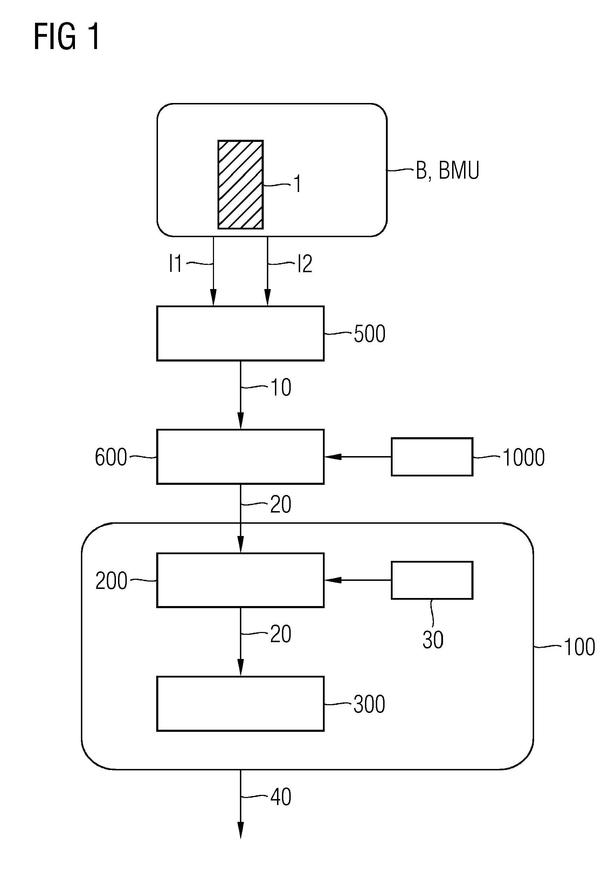

Figur 1 zeigt in einer schematischen Darstellung ein Verfahren zum Bereitstellen einer Zustandsinformation 40 einer Batteriezelle 1 mittels eines Zählers 100. Die Batteriezelle 1 ist Bestandteil einer Batterie B, welche in einem Elektrofahrzeug verbaut ist. Dort kann sie insbesondere zum Antrieb des Elektrofahrzeuges als Traktionsbatterie verbaut sein oder als Starterbatterie, insbesondere für die Versorgung der Start-Stopp-Automatik.

Zum Erfassen einer physikalischen Eigenschaft I1 der Batteriezelle 1 sind Sensoren verbaut, welche charakterisierende Daten der Batteriezelle 1, wie insbesondere eine Spannung, einen Strom oder eine Impedanz ermitteln. Eine Batteriemanagement-Unit BMU stellt überdies Parameter bereit, welche einen physikalischen Vorgang 12 beschreiben, dem die Batteriezelle 1 seit dem Einbau in das Fahrzeug und seit einer Überwachung durch die Batteriemanagement-Unit BMU ausgesetzt war. Die Batteriemanagement-Unit BMU stellt eine Historie bereit, die über erfolgte Lade- und Entladevorgänge, eine Anzahl von Tief-Entladevorgängen und einen für die Batteriezelle 1 typischerweise anzunehmenden Selbstentladungswert Auskunft gibt. Die Parameter für die jeweiligen Schritte der Historie bilden gemeinsam den physikalischen Vorgang 12. Aus der Kombination von der physikalischen Eigenschaft I1 und dem physikalischen Vorgang 12 wird mit einer frei wählbaren Gewichtung ein Zustandswert 10 gebildet.

Dieser Zustandswert 10 ist charakteristisch für die Batteriezelle 1 zu einem gegebenen Zeitpunkt. Zu einem späteren Zeitpunkt ist bei sachgemäßer Benutzung der Batteriezelle 1 ein Zustandswert 10 zu erwarten, der einen schlechteren Zustand der Batteriezelle 1 charakterisiert. Schlechter bedeutet in diesem Zusammenhang, dass die verbaute Batterie B eine geringere Leistung erbringen kann. Dies kann insbesondere bedeuten, dass ein unterer Kapazitätswert, welcher ein erneutes Aufladen der Batterie B nötig macht, schneller erreicht wird.

Es ist im Normalfall davon auszugehen, dass alle Parameter oder Sensorwerte, welche zu einem späteren Zeitpunkt als einem ersten Zeitpunkt ermittelt werden, einen schlechteren Zustandswert 10 zur Folge haben. Sowohl aufgrund von mit der Zeit stattfindenden Lade- und Entladevorgängen während einer Nutzung als auch durch Selbstentladeprozesse aufgrund einer Alterung der Batteriezelle 1, wird sich der Zustandswert 10 - sobald er einmal ermittelt ist - nicht mehr verbessern.

Verbessert sich der Zustandswert 10 im Laufe der Zeit merklich, dann ist davon auszugehen, dass eine Manipulation an der Batterie B vorgenommen wurde, oder dass durch eine Fehlfunktion entweder eines Sensors oder einer Berechnungseinheit zur Berechnung des Zustandswertes ein fehlerhafter Zählerwert ermittelt wurde.

Dem ermittelten Zustandswert 10 wird ein Zählerwert 20 nach einer vorgebbaren Zuordnungsvorschrift 1000 zugeordnet. Die Zuordnungsvorschrift 1000 bietet die Möglichkeit, eine Zusammenfassung von benachbarten Zustandswerten zu einem gemeinsamen Zählerwert 20 vorzunehmen. So ergibt sich für einen Zustandswert 10, der in kurzem zeitlichen Abstand zu einem früheren Zustandswert ermittelt wird, derselbe Zählerwert 20, falls der ermittelte Zustandswert 10 so nah an dem früheren Zustandswert liegt, dass die Zuordnungsvorschrift denselben Zählerwert 20 liefert. Dadurch kann auf vorteilhafte Weise berücksichtigt werden, dass bei der Ermittlung der physikalischen Eigenschaft I1, des physikalischen Vorgangs 12 und damit der Ermittlung des Zustandswertes 10 Messungenauigkeiten auftreten, welche auch einen Zustandswert 10 liefern können, welcher besser ist als ein zuvor ermittelter Zustandswert. In diesem Fall wird durch das Zuordnen des Zählerwertes 20 nach der vorgebbaren Zuordnungsvorschrift 1000 ein Toleranzbereich vorgegeben, innerhalb dessen eine Erhöhung des Zustandswertes 10 im Vergleich zu einer vorher erfolgten Messung als zulässig eingestuft wird.

Der Zählerwert 20 wird nun in einem Speicher 300 des Zählers 100 hinterlegt, falls der Zählerwert 20 in eine vorgegebene Richtung von einem aktuell in dem Speicher 300 abgelegten Zählerwert 30 abweicht.

Für eine Zählerstruktur, bei der ein maximaler Zählerwert den bestmöglichen Zustand der Batterie B charakterisiert und Zählerwerte in Form von positiven, natürlichen Zahlen dargestellt werden, wird als vorgegebene Richtung eine Richtung hin zu kleineren Zählerwerten gewählt. Bei einer Realisierung des Zählers 100 als nicht flüchtiger Speicher, beispielsweise Flash oder EEPROM, ist dann entsprechend nur ein Dekrementierbefehl ausführbar. Dadurch wird ein monotoner Zähler realisiert. Ein Zählerwert 20, der einen besseren Zustand der Batteriezelle 1 repräsentiert, als der aktuelle im Speicher 300 abgelegte Zählerwert 30, wird nicht abgespeichert.

Die Zustandsinformation 40 wird in Abhängigkeit von dem Zählerwert 20 bereitgestellt. Dies geschieht über eine Kommunikationsschnittstelle 400, welche als Diagnoseschnittstelle dient. Die Diagnoseschnittstelle ist beispielsweise mittels eines CAN-Busses (Kurzform für Controller Area Network-Bus oder Steuerungs-Netzwerk-Bus), Flex-Ray-Bussystems, LIN-Busses (Kurzform für Local Interconnect Network-Bus oder Lokaler verschalteter Netzwerk-Bus) über Ethernet, Bluetooth, ZigBee, RFID (Kurzform für Radio-Frequenz-Identifikation), NFC (Kurzform für Nahfeldkommunikation) oder WLAN (Kurzform für drahtloses lokales Netzwerk) an ein Analysegerät eines Batterieherstellers oder einer Vertragswerkstatt anschließbar.

Zusätzlich wird in einer Variante gefordert, dass sich das Gerät, welches die Zustandsinformation 40 über die Diagnoseschnittstelle abfragt, über ein Passwort oder ähnliches authentisiert.

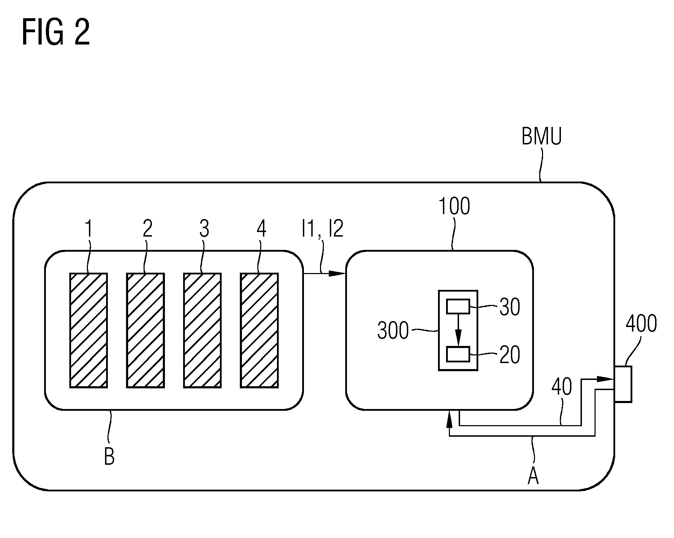

Figur 2 zeigt, wie gemäß einem zweiten Ausführungsbeispiel der Erfindung mehrere Batteriezellen einer Batterie B in die Ermittlung des Zustandswertes 40 einbezogen werden. Dazu wird ein zweiter Zustandswert 11 einer zweiten Batteriezelle 2, ein dritter Zustandswert 12 einer dritten Batteriezelle 3 und ein vierter Zustandswert 13 einer vierten Batteriezelle 4 ermittelt und daraus ein gemeinsamer Zustandswert gebildet. Dafür ist vorteilhafterweise je weiterer Batteriezelle eine weitere Sensoreinheit vorgesehen.

Der Zustandswert wird in Form ganzer natürlicher Zahlen im Wertebereich 0 bis 100 dargestellt. Eine Zuordnungsvorschrift 1000 legt fest, dass in Zweierschritten den benachbarten Zustandswerten ein gemeinsamer Zählerwert zugeordnet wird.

Als Speicher 100 dienen so genannte Security Fuses. Ein Zählerwert ist dabei einer Sicherung zugeordnet. Wird der Zählerwert 20 errechnet, so wird die zugeordnete Sicherung durchgebrannt. Durch diesen physikalischen Vorgang wird beispielsweise ein Kontakt unterbrochen und dieser Vorgang ist nicht wieder rücksetzbar.

Damit der Zählerwert 20 hinterlegt wird, ist es notwendig, dass der Zählerwert 20 einer Sicherung entspricht, welche noch nicht durchgebrannt wurde. Wurde beispielsweise die Sicherung, die dem abgelegten Zählerwert 30 mit einem Wert von 49 entspricht, bereits durchgebrannt, so ist es nicht möglich, nun den Zählerwert 20 zu hinterlegen, der einem Wert von 50 entspricht. Beim Brennen einer Sicherung werden alle Sicherungen ausgehend von einem Startpunkt bis hin zu der zu brennenden Sicherung gebrannt. Im Beispiel wurden entsprechend bei Hinterlegung des Wertes 49 bereits der Wert 50 und der Wert 49 gebrannt. Der Startpunkt wird durch eine vorher erfolgte Messung festgelegt oder ist durch die Gesamtzahl aller vorhandenen Sicherungen festgelegt.

Durch die Zuordnungsvorschrift können zur Verfügung stehende Security Fuses an eine Zustandswertstruktur angepasst werden. Die Zustandsinformation 40 kann damit in einem gröberen Raster bereitgestellt werden, als der Zustandswert 10 selbst. Beispielsweise können nur 32 Security Fuses vorgesehen sein, wobei jeder Security Fuse acht Zustandswerte zugeordnet sind, so dass 256 Zustandswerte durch 32 Zustandsinformationen repräsentiert werden. In einer anderen, nicht dargestellten Variante, ist der monotone Zähler dadurch realisiert, dass der Zählerwert in einen Speicher abgelegt wird, wobei durch eine Schaltung bei einem Schreibzugriff geprüft wird, dass der neu zu schreibende Wert kleiner ist oder bei dualer Codierung größer ist als der aktuell gespeicherte Wert. Andernfalls erfolgt kein Schreibvorgang.

In einer Variante wird die Zustandsinformation durch eine kryptographische Prüfsumme geschützt bereitgestellt und umfasst vorzugsweise ferner eine Identifizierungsinformation der Batterie B.

Der Zähler 100 kann insbesondere Bestandteil einer Batteriemanagementeinheit BMU sein. Es kann in einer Variante ferner möglich sein, für eine jede Batteriezelle der Batterie B einen separaten Zähler vorzusehen. Dies erschwert eine Manipulation der Zustandsinformation 40, da der Zählerwert 20 einer jeden Batteriezelle vor Manipulation geschützt wird.

In einer Variante kann der Zähler 100 in einem vorhandenen Steuergerät eines Fahrzeuges realisiert sein, beispielsweise in einem Wegfahrsperr-Steuergerät oder in einem Antriebsstrang-Steuergerät.

Die Zustandsinformation 40 kann in einem Kombidisplay eines Elektrofahrzeuges dargestellt werden. Dabei kann der Zählerwert 20 auf einer Skala abgebildet werden oder ein Hinweis ausgegeben werden, wenn das Hinterlegen des Zählerwertes möglich war, so dass eine Manipulation ausgeschlossen wird.

Das Verfahren und die Vorrichtung gemäß den Ausführungsbeispielen der Erfindung betrifft insbesondere eine Fahrzeugbatterie zum Beispiel für ein Kraftfahrzeug mit Verbrennungsantrieb und Starterbatterie, ein Hybridfahrzeug oder ein reines Elektrofahrzeug. Es kann sich bei dem Fahrzeug z.B. um einen PKW, LKW, Bus, Straßenbahn, Zug, Lokomotive, Schiff, U-Boot, Elektrofahrrad, Motorrad, Gabelstapler, Baumaschine, Gartengerät wie beispielsweise Rasenmäher, oder ein Flurförderfahrzeug handeln. Das Verfahren und die Vorrichtung sind auch für andere Batterien anwendbar, z.B. für eine Batterie einer Notstromversorgung, eines Haushaltsgeräts oder einer stationären Energiepufferung eines Stromnetzes.

Die Sensoreinheit 500, die Analyseeinheit 600 sowie der Speicher 300 können in Software, Hardware oder in einer Kombination aus Soft- und Hardware realisiert und ausgeführt werden.

So können die durch die Einheiten realisierten Schritte als Programm-Code auf einem Speichermedium, insbesondere einer Festplatte, CD-ROM oder einem Speichermodul abgelegt sein, wobei die einzelnen Anweisungen des Programmcodes von mindestens einer Recheneinheit, umfassend einen Prozessor, ausgelesen und verarbeitet werden. Der Prozessor ist mit dem Speichermedium über einen Bus zum Datenaustausch verbunden.

Ferner kann eine Ein-Ausgabe-Einheit über den Bus angeschlossen werden, wobei mittels der Ein-Ausgabe-Einheit Daten, wie beispielsweise Nachrichten oder Schlüssel, empfangen und/oder versendet werden können.

## Patentansprüche

1. Verfahren zum Bereitstellen einer Zustandsinformation (40) mindestens einer Batteriezelle (1) mittels eines Zählers (100), umfassend folgende Schritte:
- Ermitteln mindestens eines Zustandswertes (10), wobei der mindestens eine Zustandswert (10) in Abhängigkeit von einer physikalischen Eigenschaft (I1) der Batteriezelle (1) und/oder einem physikalischen Vorgang (12), dem die Batteriezelle (1) vor dem Ermitteln ausgesetzt war, gebildet wird;
- Zuordnen eines Zählerwertes (20) in Abhängigkeit von dem mindestens einen Zustandswert (10) nach einer vorgebbaren Zuordnungsvorschrift (1000);
- Hinterlegen des Zählerwertes (20) in einem Speicher (300) des Zählers (100), falls der Zählerwert (20) in eine vorgegebene Richtung von einem aktuell in dem Speicher (300) abgelegten Zählerwert (30) abweicht;
- Bereitstellen der Zustandsinformation (40) in Abhängigkeit von dem Zählerwert (20).

2. Verfahren nach Anspruch 1, wobei der Zählerwert (20) als diskrete Zahl codiert zugeordnet wird.

3. Verfahren nach Anspruch 1 oder 2, wobei der Speicher (300) durch Security Fuses gebildet wird.

4. Verfahren nach Anspruch 1 oder 2, wobei der Speicher (300) durch einen nicht-flüchtigen Speicher mit einer Ansteuerungslogik gebildet wird.

5. Verfahren nach einem der vorstehenden Ansprüche, wobei die physikalische Eigenschaft (I1) aus einer Kombination aus physikalischen Werten gebildet wird und wobei die physikalischen Werte insbesondere ein Widerstandswert, ein Kapazitätswert oder ein Spannungswert sind.

6. Verfahren nach einem der vorstehenden Ansprüche, wobei der physikalische Vorgang 12 aus einem oder mehr Schritten gebildet wird und für jeden Schritt ein Parameter ermittelt wird, insbesondere eine Anzahl von Lade- und/oder Entladevorgängen, eine Anzahl von Tiefentladevorgängen, eine Umgebungstemperatur, ein Selbstentladungswert oder eine Erschütterung.

7. Verfahren nach einem der vorstehenden Ansprüche, wobei
- mindestens ein zweiter Zustandswert (11) einer zweiten Batteriezelle (2) ermittelt wird;
- einem gemeinsamen Zustandswert, der aus dem Zustandswert (10) und dem zweiten Zustandswert (11) zusammengesetzt wird, der Zählerwert zugeordnet wird.

8. Verfahren nach einem der vorstehenden Ansprüche, wobei die Zustandsinformation (40) durch eine kryptographische Prüfsumme geschützt bereitgestellt wird.

9. Verfahren nach einem der vorstehenden Ansprüche, wobei die Zustandsinformation (40) ferner eine Identifizierungsinformation der mindestens einen Batteriezelle (1) umfasst.

10. Verfahren nach einem der vorstehenden Ansprüche, wobei die Zustandsinformation ferner Informationen über registrierte Umgebungsdaten der mindestens einen Batteriezelle (1) umfasst.

11. Vorrichtung zum Bereitstellen einer Zustandsinformation (40) mindestens einer Batteriezelle (1), umfassend:
- eine Sensoreinheit (500) zum Ermitteln mindestens eines Zustandswertes (10) aus einer physikalischen Eigenschaft (I1) der Batteriezelle (1) und/oder einem physikalischen Vorgang (12), dem die Batteriezelle vor dem Ermitteln ausgesetzt war;
- eine Analyseeinheit (600) zum Zuordnen eines Zählerwertes (20) in Abhängigkeit von dem mindestens einen Zustandswert (10) nach einer vorgebbaren Zuordnungsvorschrift (1000) ;
- einen Zähler (100) und einen Speicher (300) des Zählers (100) zum Hinterlegen des Zählerwertes (20), falls der Zählerwert (20) in eine vorgegebene Richtung von einem aktuell in dem Speicher (300) abgelegten Zählerwert (30) abweicht;
- eine Kommunikationsschnittstelle (400) zum Bereitstellen der Zustandsinformation (40) in Abhängigkeit von dem Zählerwert (20).

12. Vorrichtung nach Anspruch 11, ferner eine weitere Einheit umfassend zur Verwendung in einem der Verfahrensschritte gemäß den Ansprüchen 2 bis 10.
